# EUROPÄISCHE PATENTSCHRIFT

(11) **EP 1 256 264 B1**
(45) Veröffentlichungstag und Bekanntmachung des Hinweises auf die Patenterteilung: **09.07.2003**
(21) Anmeldenummer: 01911577.3
(22) Anmeldetag: 02.02.2001
(51) Int. Cl.: H05K 7/20

(54) **KÜHLVORRICHTUNG**
COOLING DEVICE
DISPOSITIF DE REFROIDISSEMENT

(30) Priorität: 02.02.2000 DE 10004474
(43) Veröffentlichungstag der Anmeldung: 13.11.2002
(73) Patentinhaber: Rittal GmbH & Co. KG, 35745 Herborn (DE)
(72) Erfinder: EDELMANN, Achim, 57234 Wilnsdorf-Wilden (DE)
(74) Vertreter: Fleck, Hermann-Josef, Dr.-Ing.
(86) Internationale Anmeldenummer: EP0101101
(87) Internationale Veröffentlichungsnummer: WO01058231

(56) Entgegenhaltungen:
- EP-A- 0 472 269
- DE-A- 19 704 549
- US-A- 3 586 102
- US-A- 5 040 381
- US-A- 5 887 435

## Beschreibung

Die Erfindung betrifft eine Kühlvorrichtung zum Kühlen von einer oder mehreren Elektrik- und/oder Elektronik-Komponenten (nachfolgend kurz E-Komponenten genannt), mit wenigstens einem Kühlkörper, der der E-Komponente zugeordnet ist und mit dieser in wärmeleitender Verbindung steht.

Eine Kühlvorrichtung gemäß dem Oberbegriff des Anspruchs 1 ist z.B. aus DE-A-19704549 bekannt.

Bei bekannten Kühlvorrichtungen werden als Kühlkörper Peltier-Elemente verwendet. Deren Kühlseite ist in wärmeleitenden Kontakt mit der Oberfläche der E-Komponente gebracht. Um eine efektive Wärmeabfuhr erreichen zu könenn, ist ein möglichst luftspaltfreier Oberflächenkontakt erforderlich. Nun sind aber die Oberflächen von E-Komponenten und die der Kühlkörper vielfältig, so dass eine ideale Wärmeübertragung nur bei Spezialanfertigungen mit angepassten Oberflächenstrukturen stattfinden kann.

Es ist Aufgabe der Erfindung, eine Kühlvorrichtung der eingangs erwähnten Art zu schaffen, bei der mit geringem Aufwand eine effektive Wärmeübertragung zwischen den E-Komponenten einerseits und dem Kühlkörper andererseits stattfindet.

Diese Aufgabe der Erfindung wird durch die im kennzeichnenden Teil des Anspruchs 1 beanspruchten Merkmalen gelöst.

Gemäß einer bevorzugten Ausgestaltungsvariante der Erfindung ist es vorgesehen, dass das pastöse Füllmaterial als ein Gel mit hoher Wärme-Speicherkapazität ausgebildet ist. Das Gel hat insbesondere aufgrund seiner Wärmespeicherkapazität eine Pufferkapazität. Mit dieser können E-Komponente, bei denen wechselnde Wärmemengen abgetauscht werden müssen, effektiv gekühlt werden. Darüber hinaus ist das Gel eine homogene Masse, die die Verformungen der Membrane leicht ausgleicht und gleichzeitig eine hohe Wärmeübertragungsrate gewährleistet.

Die Kühlvorrichtungen sind erfindungsgemäß als Peltier-Elemente ausgebildet. Dabei ist es insbesondere vorgesehen, dass die Peltier-Elemente auf einer Halterung befestigt oder in diese eingearbeitet, beispielsweise eingegossen sind und dass die Halterung aus einem wärmeleitfähigen Material besteht. Hierbei kann das Füllmaterial sowohl in Kontakt mit der Halterung und den Peltier-Elementen, oder wenn die Peltier-Elememte vollständig eingegossen sind, in Kontakt nur mit der Halterung stehen.

Wenn die erfindungsgemäße Kühlvorrichtung in einem Gehäuse, beispielsweise einem Elektronik-Kleingehäuse oder einem Schaltschrank betrieben wird, muß eine Wärmeabführung von der Kühlvorrichtung bereitgestellt werden. Aus diesem Grund kann es vorgesehen sein, dass die Halterung an einem Gehäuse fixiert ist und mit einer Wärmetauscherseite in Kontakt mit dem, das Gehäuse umgebenden Bereich und/oder mit einer Gehäusewandung steht, und dass die Halterung im Bereich der Wärmetauscherseite eine Kühlrippen aufweisende Wärmetauscherstruktur aufweist.

Damit die Aneinanderfügung von E-Komponenten und der Membrane einfach durchgeführt werden kann, sieht eine mögliche Erfindungsausgestaltung vor, dass die E-Komponenten auf einer Platine montiert sind, die über ein oder mehrere Trägerelemente in dem Gehäuse fixiert ist, dass wenigstens eines der Trägerelemente an eine Führung angekoppelt ist, mittels derer die Platine in Richtung auf das flüssige oder pastöse Material verstellbar ist. Alternativ oder zusätzlich kann auch vorgesehen sein, dass das flüssige oder pastöse Material an einer Halterung gehalten ist, und dass die Halterung mittels einer Führung in Richtung auf die E-Komponente(-n) verstellbar ist.

Die Erfindung wird im Folgenden anhand eines in den Zeichnungen dargestellten Ausführungsbeispieles näher erläutert. Es zeigen:
- Fig. 1: in schematischer Darstellung ein Gehäuse mit einer Kühlvorrichtung in Seitenansicht und im Schnitt und
- Fig. 2: die Darstellung gemäß Fig. 1 in einer veränderten Montageposition

In den Zeichnungen ist ein Gehäuse 10 dargestellt, das ein Deckelteil 11 und eine Boden 12 aufweist. Ein Teil der Seitenwand des Gehäuses 10 wird von einer Halterung 17 gebildet. Diese Halterung 17 ist aus einem Aluminiumguß gefertigt.

Außenseitig weist die Halterung 17 vorstehende Kühlrippen 19 auf, die zueinander parallel beabstandet angeordnet sind. Die Kühlrippen 19 sind einstückig mit der Halterung 17 verbunden. Das Material für die Halterung 17 kann auch ein anderes als Aluminium sein. Es ist zu beachten, dass dieses Material jedoch eine hohe Wärmeleitfähigkeit aufweist. In die Halterung 17 sind vier Peltier-Elemente eingegossen, die als Kühlkörper 18 dienen. Selbstver-ständlich sind auch mehr oder weniger als vier Peltier-Elemente einsetzbar. Die Anzahl der eingesetzten Peltier-Elemente hängt von der abzuführenden Wärmemenge ab.

Auf der dem Innenraum des Gehäuses 10 zugewandten Seite besitzt die Halterung 17 eine ebene Kühlfläche. Diese Kühlfläche wird von einer Membrane 16.1 kissenförmig überspannt. Zwischen der Membrane 16.1 und der Kühlfläche der Halterung 17 ist ein Füllmaterial 16, vorliegend ein pastöses Gel, gehalten. Die Membrane 16.1 ist aus einem flexiblen Material, beispielsweise einer Kunststofffolie gebildet. Dabei ist darauf zu achten, dass die Membrane 16.1 ebenso wie das Füllmaterial 16 eine gute Wärmeleitfähigkeit aufweist.

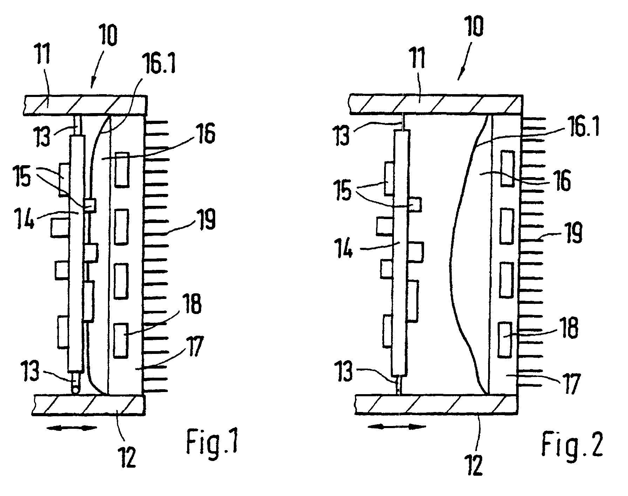

Beabstandet zu der Halterung 17 ist im Innenraum des Gehäuses 10 eine Platine 14 gehalten. Die Platine 14 kann eine Baugruppe sein. Dementsprechend ist das Gehäuse 10 ein Baugruppenträger. Die Platine 14 ist über Trägerelemente 13 jeweils an das Deckelteil 11, bzw. den Boden 12 angebunden. Die Anbindung erfolgt über Führungen, die einen Versatz der Platine 14 parallel zur Bildebene erlauben. Die Versatzrichtung ist in den Fig. 1 und 2 mit einem Doppelpfeil gekennzeichnet. Auf der Platine 14 sind beidseitig Elektronik-, bzw. Elektronik-Komponenten (E-Komponenten 15) montiert.

Ausgehend aus der in Fig. 2 gezeigten Ausgangslage wird die Platine 14 in Richtung auf die Halterung 17 mittels der Führungen verschoben, bis sie ihre, in Fig. 1 gezeigte Montagestellung erreicht. In dieser Montagestellung wird die Platine 14 arretiert. Beim Übergang in die Montagestellung schmiegt sich die Außenseite der Membrane 16.1 an die Oberfläche der E-Kompontenten 15 an. Hierdurch wird ein großflächiger und inniger Kontakt zwischen den E-Komponenten 15 und der Membrane 16.1 bewirkt.

Im Betrieb geben die E-Komponenten 15 ihre Verlustleistung in Form von Wärme über die Membrane 16.1 an das Füllmaterial 16 ab. Da das Füllmaterial 16 eine gute Wärmeleitfähigkeit aufweist, wird die Wärme über die Halterung 17 an die Kühlkörper 18 weitergeführt. Die der Außenseite des Gehäuses 10 zugeordnete warme Seite der Kühlkörper 18 führt dann die Verlustwärme in die Umgebung ab, was effektiv über die Kühlrippen 19 geschehen kann.

## Patentansprüche

1. Kühlvorrichtung zum Kühlen von einer oder mehreren Elektrik- und /oder Elektronik-Komponenten (nachfolgend kurz "E-Komponenten" genannt), mit wenigstens einem Kühlkörper, der der E-Komponente zugeordnet ist und mit dieser in wärmeleitender Verbindung steht, wobei der Kühlkörper (18) in wärmeleitendem Kontakt mit einem flüssigen oder pastösen, wärmeleitfähigem Füllmaterial steht, wobei das flüssige oder pastöse Material zumindest bereichsweise von einer flexiblen Membrane gehalten ist, wobei die Membrane (16.1) in Oberflächenkontakt mit der E-Komponente steht, und wobei die E-Komponente (15) auf einer Platine (14) montiert sind, die über ein oder mehreren Trägerelementen (13) in dem Gehäuse (10 fixiert Ist,
dadurch gekennnzeichnet,
dass die Kühlkörper (18) als Peltierelemente ausgebildet sind, die auf einer Halterung (17) befestigt oder in diese eingearbeitet, beispielsweise eingegegossen, sind,
dass die Halterung aus einem wärmeleitfähigen Material besteht und
dass wenigstens eines der Trägerelemente an eine Führung angekoppelt ist, mittels derer die Ptatine (14) in Richtung auf das flüssige oder pastöse Material (16) verstellbar ist.

2. Kühlvorrichtung nach Anspruch 1,
**dadurch gekennzeichnet,**
**dass** das pastöse Füllmaterial (16) als ein Gel mit hoher Wärme-Speicherkapazität ausgebildet ist.

3. Kühlvorrichtung nach Anspruch 1 oder 2,
**dadurch gekennzeichnet,**
**dass** die Halterung (17) an einem Gehäuse (10) fixiert ist und mit einer Wärmetauscherseite in Kontakt mit dem das Gehäuse (10) umgebenden Bereich und/oder mit einer Gehäusewandung (10, 12) steht, und
**dass** die Halterung im Bereich der Wärmetauscherseite eine Kühlrippen (19) aufweisende Wärmetauscherstruktur aufweist.

4. Kühlvorrichtung nach einem der Ansprüche 1 bis 4,
**dadurch gekennzeichnet,**
**dass** das flüssige oder pastöse Material (16) an einer Halterung (17) gehalten ist, und
**dass** die Halterung mittels einer Führung in Richtung auf die E-Komponente(-n) verstellbar ist.

## Claims

1. Cooling apparatus for cooling one or more electrical and/or electronic components (referred to hereinbelow as "e components" for short), having at least one cooling body which is assigned to the e component and is in thermally conductive connection therewith, it being the case that the cooling body (18) is in thermally conductive contact with a liquid or pasty, thermally conductive filling material, that the liquid or pasty material is retained, at least in certain regions, by a flexible membrane, that the membrane (16.1) is in surface contact with the e component, and that the e component (15) is fitted on a printed circuit board (14) which is fixed in the housing (10) via one or more carrier elements (13), **characterized in that** the cooling bodies (18) are designed as Peltier elements which are fastened on a mount (17) or are made, for example cast, therein, **in that** the mount consists of a thermally conductive material, and **in that** at least one of the carrier elements is coupled to a guide by means of which the printed circuit board (14) can be adjusted in the direction of the liquid or pasty material (16).

2. Cooling apparatus according to Claim 1, **characterized in that** the pasty filling material (16) is in the form of a gel with a high heat-storage capacity.

3. Cooling apparatus according to Claim 1 or 2, **characterized in that** the mount (17) is fixed on a housing (10) and is in contact, by way of a heat-exchanger side, with the region enclosing the housing (10) and/or with a housing wall (10, 12), and **in that**, in the region of the heat-exchanger side, the mount has a heat-exchanger structure having cooling ribs (19).

4. Cooling apparatus according to one of Claims 1 to 3, **characterized in that** the liquid or pasty material (16) is retained on a mount (17), and **in that** the mount can be adjusted in the direction of the e component(s) by means of a guide.

## Revendications

1. Dispositif de refroidissement pour le refroidissement d'un ou de plusieurs composants électriques et/ou électroniques (ci-dessous appelés en abrégé "composants E"), avec au moins un corps de refroidissement qui est associé au composant E et qui est en liaison thermiquement conductrice avec ces derniers, le corps de refroidissement (18) étant en contact thermiquement conducteur avec un matériau de remplissage liquide ou pâteux et thermiquement conducteur, le matériau liquide ou pâteux étant retenu au moins par zones par une membrane flexible, la membrane (16.1) étant en contact de surface avec le composant E, et les composants E (15) étant montés sur une plaque (14) qui est fixée dans le boîtier (10) par l'intermédiaire d'un ou de plusieurs éléments de support (13), **caractérisé en ce que** les corps de refroidissement (18) sont configurés comme éléments Peltier qui sont fixés sur un support (17) ou sont incorporés dans ce dernier, par exemple par moulage, **en ce que** le support est constitué d'un matériau thermiquement conducteur et **en ce qu'**au moins l'un des éléments de support est couplé à un guide au moyen duquel la plaque (14) peut être déplacée en direction du matériau liquide ou pâteux (16).

2. Dispositif de refroidissement selon la revendication 1, **caractérisé en ce que** le matériau de remplissage pâteux (16) est configuré comme gel à haute capacité d'accumulation thermique.

3. Dispositif de refroidissement selon la revendication 1 ou 2, **caractérisé en ce que** le support (17) est fixé sur un boîtier (10) et est en contact par son côté d'échange de chaleur avec la région qui entoure le boîtier (10) et/ou avec une paroi du boîtier (10, 12) et **en ce que** le support présente une structure d'échangeur de chaleur qui présente des ailettes de refroidissement (19) dans la région du côté d'échange de chaleur.

4. Dispositif de refroidissement selon l'une quelconque des revendications 1 à 4, **caractérisé en ce que** le matériau liquide ou pâteux (16) est maintenu sur un support (17) et **en ce que** le support peut être déplacé en direction du ou des composants E au moyen d'un guide.
